# EUROPEAN PATENT SPECIFICATION

(11) **EP 0 201 135 B1**
(45) Date of publication and mention of the grant of the patent: **08.03.1995**
(21) Application number: 86200780.4
(22) Date of filing: 05.05.1986
(51) Int. Cl.: A01B 49/06

(54) **A soil cultivating machine**
Bodenbearbeitungsmaschine
Machine pour le travail du sol

(30) Priority: 07.05.1985 NL 8501286; 07.05.1985 NL 8501285
(43) Date of publication of application: 17.12.1986
(73) Proprietor: C. van der Lely N.V., NL-3155 PD Maasland (NL)
(72) Inventor: Van der Lely, Cornelis, Zug (CH)
(74) Representative: Mulder, Herman

(56) References cited:
- AT-B- 342 906
- DE-A- 2 462 240
- DE-A- 2 738 211
- FR-A- 2 284 264
- FR-A- 2 342 015
- FR-A- 2 414 856
- FR-A- 2 499 817
- GB-A- 2 139 462
- NL-A- 7 200 225
- US-A- 1 916 330
- US-A- 2 667 362
- US-A- 4 088 083
- US-A- 4 509 438

## Description

The invention relates to a combined soil cultivating machine for sowing fine seed, such as grass seed, in a top layer of the soil, as defined in the preamble of claim 1

Machines of this kind as known from GB.A.1568621 are usually not suitable for sowing very fine seed, such as grass seed.

The construction according to the invention provides a soil cultivating machine of the above-defined kind, which machine is perfectly suitable for sowing fine seed such as grass seed.

According to the invention, this is accomplished by the characterising features of claim 1.

When using this construction, the risk that the fine seed is dispersed too much is slight, and the seed can be effectively brought into contact with the upper layer of the cultivated soil, such that the required germination conditions for the seed are satisfied to a maximum extent.

For a better understanding of the invention and to show how the same may be carried into effect, reference will now be made, by way of example, to the accompanying drawings, in which:
Figure 1 is a plan view of a machine comprising a construction according to the invention;
Figure 2 is a view taken in the direction of the arrow II in Figure 1.

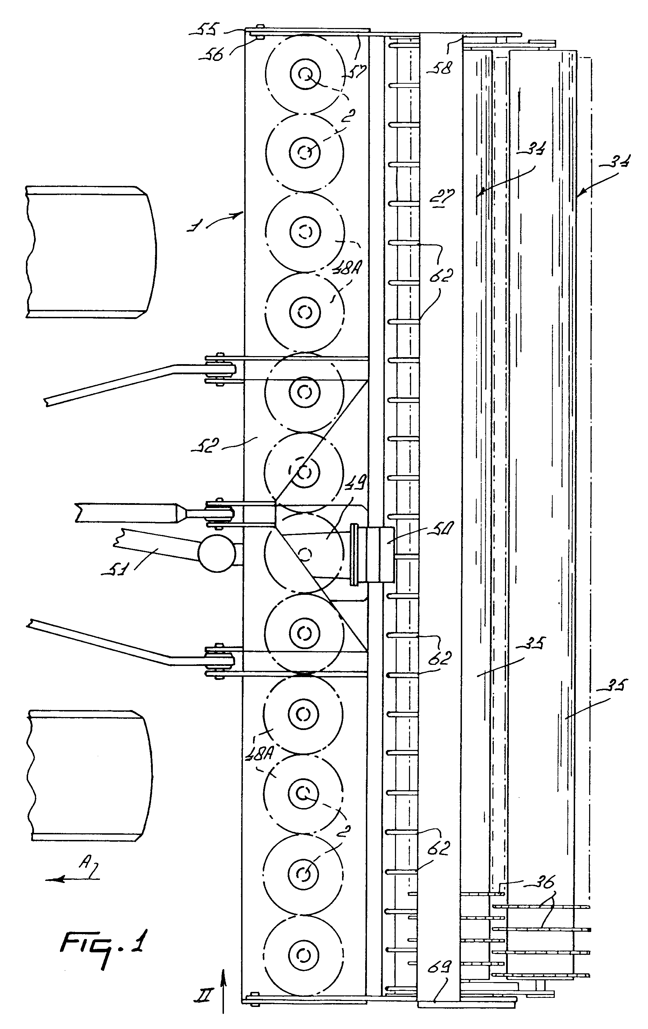

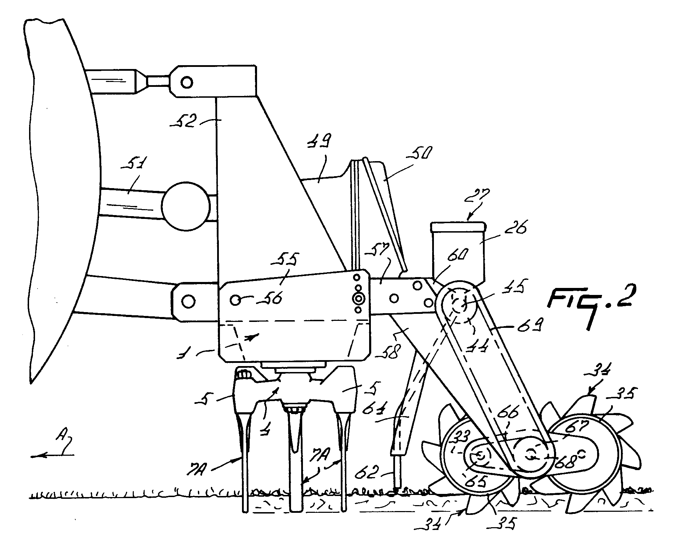

The apparatus shown in Figures 1 and 2 is an agricultural machine, more specifically a soil cultivating machine for preparing a seed bed. The machine comprises a box-like frame portion 1 extending transversely of the intended direction of operative travel A and extending at least substantially horizontal.

In the box-like frame portion 1, the upwardly extending, preferably vertically extending, shafts 2 of soil working members 3 are supported at relative equal distances of preferably 25 centimeters. Each of the soil working members 3 includes a carrier 4 which extends at least substantially horizontally and is mounted on the lower end of a shaft 2, which end projects from the frame portion 1. At its ends, the carrier 4 accommodates a bushing 5, whose longitudinal centre line extends at least substantially parallel with the rotary axis of a soil working member 3. A fastening portion 6 of a tine 7A is disposed in each of the bushings 5. The ends of the box-like frame portion 1 are closed by upwardly directed plates 55, which are located at least substantially parallel to the direction of operative travel A. Near the leading side, each plate 55 has, above the upper side of the box-like frame portion 1, a pin 56 which extends transversely of the direction of operative travel A and above which one end of an arm 57 is freely rotatable. Behind the box-like frame portion, the arm 57 merges into a support 58 for a roller 34 which support extends downwardly and rearwardly. The upper side of each support 58 is provided with strips 60 (Figure 2) which extend at a rearward and upward angle and accommodate a hopper 26 of a grass seed drill 27. Discharge members 61 are provided, which comprise a vertically downwardly extending portion 62 which ends before the roller 34 at the level of the bottom side of the tubular part 35 of this roller. The portions 62 of the discharge members 61 are supported by a common support 63 which, by means of arms 64, is mounted at the front of the support 58. A transmission 41 - 49 is provided for driving the discharge mechanism of the seed drill 27. The arms 57 are adjustable in height with the aid of a known adjusting means 57A and consequently also the roller 34 for setting the working depth of the tines 7A.

The roller 34 is provided with a tandem system of two rollers 34, these rollers being so arranged relative to each other that the combs 36 on one roller move between the combs 36 on the other roller. Driving of the discharge mechanism of the seed drill 27 is effected in this embodiment from a sprocket 65 on a shaft 33 of the foremost roller 34 via a chain 66 and two adjacent sprockets 67 provided on a shaft 68 disposed between the rollers 34. A chain 69 is passed around the outermost sprocket 67 and also around the sprocket 44 on the shaft of the discharge mechanism of the seed drill 27. The working depth of the blade-like tines 7A can be set with the aid of the rollers 34 and this working depth is preferably such that the tines leave a cultivated layer of soil of 3 - 5 centimeters thick. The seed drill 27 can be adjusted, together with the rollers 34, in the vertical direction relative to the box-like frame portion 1, whereby the drive for the discharge mechanism of the seed drill 27 is maintained. The rearmost roller may comprise round-tipped scraper members, by means of which it is achieved that the earth is removed very gradually from the tubular portion 35 of the roller 34, thus preventing the forming of clods.

Furthermore, the combs of the last roller effect scraping of the earth of the first roller. Clogging can be easily obviated by means of the rounded tips of the scraper elements 40.

The mode of operation of the machine is as follows:
During operation, the machine is coupled by means of the trestle 52 to the three-point lifting hitch of a tractor and can be moved by means of the tractor in the direction indicated by the arrow A; the soil working members 3 being rotatable from the power take-off shaft via the intermediate shaft and the above-described transmission means. Hereby, adjacent soil working members 3 are driven in opposite directions relative to each other and the blade-like tines 7A cultivate at least adjoining strips of soil. The roller 34 is disposed such that the distance between the circumference formed by the path described by the ends of the combs 36 and the path described by a soil working member 3, more specifically by the blade-like tines 7A of the soil working members 3, are located in each other's immediate vicinity, preferably spaced-apart by approximately 5 centimeters.

The machine described in the foregoing is particularly suitable for preparing a seed bed and subsequent sowing of grass seed. To that end, such a working depth can be set with the aid of the roller 34 that the tines 7A cultivate a 3 - 5 centimeters thick layer of soil. During travel of the machine in the direction of the arrow A, fertilizer is fed in front of the soil workin members, whereas the grass seed is discharged near the bottom side of the roller 34 into the rearwardly displaced earth. Discharging the grass seed from a low position may result in a reduced spread, so that op tionally a greater density of the spread pattern can be obtained, whilst, in addition, the risk of the grass seed being dispersed by the wind is reduced. The seed drill 27 can be adjusted in height together with the roller 34.

## Claims

1. A combined soil cultivating machine for sowing fine seed such as grass seed in a top layer of soil, comprising a frame and soil working members (3) rotatable about upwardly extending axes, the machine further comprising a seeder for sowing said seed in the top layer of the soil and a roller, with the aid of which the working depth of the soil working members can be adjusted, whereby outlet openings of the seeder in the form of tubular discharge members (27) are located between the soil working members (3) and the roller, and wherein the roller is provided with a tandem system of two rollers (34) co-operating in a soil shedding manner, **characterised in that** these rollers are constituted mainly by a tubular part (35) and in that the discharge openings of the tubular members (27) discharge without any intermediate arrangement in front of the foremost roller and at the level of the bottom side of the said tubular part (35), so that the seed is discharged during operation near the bottom side of said roller above and close to the surface of the cultivated soil, while the seed further is brought into contact with the upper layer of an about 3-5 cm thick layer of soil, cultivated by the soil working members.

2. A soil cultivating machine as claimed in claim 1, characterized in that the roller (34) comprises a tubular portion (35) having combs (36) and in that the combs (36) are spaced apart, while scraper elements (40) are provided between the combs (36), the said scraper elements (40) at the one side being concave and having a rounded tip at least near the tubular portion (35).

## Patentansprüche

1. Kombinierte Bodenbearbeitungsmaschine zum Einsäen von feinem Saatgut, wie z. B. Grassamen, in eine obere Schicht des Bodens, mit einem Rahmen und Bodenbearbeitungsgliedern, die um aufwärts gerichtete Achsen drehbar sind, wobei die Maschine ferner eine Sävorrichtung zum Einsäen des Saatgutes in die obere Schicht des Bodens sowie eine Walze aufweist, mittels der die Arbeitstiefe der Bodenbearbeitungsglieder einzustellen ist, wobei ferner zwischen den Bodenbearbeitungsgliedern und der Walze Auslaßöffnungen der Sävorrichtung in Form von rohrförmigen Auslaßteilen (62) angeordnet sind, und wobei die Walze durch ein Tandem aus zwei Walzen (34) gebildet ist, die zum Ablösen von Erde zusammenwirken,
dadurch gekennzeichnet, daß diese Walzen hauptsächlich aus einem rohrförmigen Körper (35) bestehen, und daß die Auslaßöffnungen der rohrförmigen Auslaßteile (62) das Saatgut ohne zwischengeordnete Einrichtung vor der vorderen Walze und in Höhe der Unterseite des rohrförmigen Körpers (35) abgeben, so daß das Saatgut im Betrieb nahe der Unterseite dieser Walze über dem bearbeiteten Boden und nahe dessen Oberfläche ausgebracht wird, wobei das Saatgut ferner mit der oberen Schicht einer etwa 3 bis 5 cm dicken, von den Bodenbearbeitungsgliedern bearbeiteten Bodenschicht in Kontakt gebracht wird.

2. Bodenbearbeitungsmaschine nach Anspruch 1,
dadurch gekennzeichnet, daß die Walze (34) einen rohrförmigen Körper (35) mit Zahnkränzen (36) aufweist, und daß die Zahnkränze (36) mit Abstand zueinander angeordnet sind, wobei zwischen den Zahnkränzen (36) Abstreifer vorgesehen sind, die auf ihrer einen Seite konkav ausgebildet sind und zumindest nahe dem rohrförmigen Körper (35) eine abgerundete Spitze aufweisen.

## Revendications

1. Machine combinée pour cultiver le sol pour semer des graines fines telles que des graines d'herbe dans une couche supérieure du sol, comprenant un châssis et des organes de travail du sol rotatifs autour d'arbres s'étendant vers le haut, la machine comprenant en outre un semoir pour semer lesdites graines dans la couche supérieure du sol et un rouleau à l'aide duquel la profondeur de travail des organes de travail peut être réglée, des ouvertures de sortie du semoir sous la forme d'organes de décharge tubulaires (62) étant situées entre les organes de travail du sol et le rouleau, et dans laquelle le rouleau est prévu avec un système en tandem de deux rouleaux (34) coopérant de manière à répandre la terre, **caractérisée en ce que** ces rouleaux sont constitués principalement par une partie tubulaire (35) et en ce que les ouvertures de décharge des organes tubulaires (62) déchargent sans aucun agencement intermédiaire directement en avant du rouleau antérieur et au niveau du côté inférieur de ladite partie tubulaire (35) de telle sorte que les graines sont déchargées pendant le travail près du côté inférieur dudit rouleau, au dessus de la surface du sol cultivé et près de celle-ci, tandis que les graines sont en outre mises en contact avec la couche supérieure d'une couche de terre ayant environ 3 à 5 cm d'épaissuer par les organes de travail du sol.

2. Machine pour cultiver le sol selon la revendication 1, **caractérisée en ce que** le rouleau (34) comprend une partie tubulaire (35) ayant des peignes (36) et en ce que les peignes (36) sont espacés entre eux, tandis que des éléments racleurs sont prévus entre les peignes (36), lesdits éléments racleurs sur un côté étant concaves et ayant une extrémité arrondie, au moins à proximité de la partie tubulaire (35).
